# EUROPEAN PATENT APPLICATION

(11) **EP 1 814 155 A1**
(43) Date of publication of application: **01.08.2007**
(21) Application number: 05765288.5
(22) Date of filing: 01.07.2005
(51) Int. Cl.: H01L 27/14, G03B 11/00, H04N 5/335

(54) **LIGHT RECEIVING DEVICE, METHOD FOR FABRICATING SAME, AND CAMERA**

(30) Priority: 16.11.2004 JP 2004332265
(71) Applicant: MATSUSHITA ELECTRIC INDUSTRIAL CO., LTD., Osaka 571-8501 (JP)
(72) Inventor: TSUKAMOTO, Akira, Matsushita Electric Ind. Co., Ltd.. Ind, Chuo-ku , Osaka-shi, Osaka 540-6319 (JP)
(74) Representative: Grape & Schwarzensteiner
(86) International application number: PCT/JP2005/012231
(87) International publication number: WO 2006/054376

(57) **Abstract**

The light receiving device of the present invention includes: a light receiving portion formed on a semiconductor substrate; and a light transmitting portion made of an organic material on an optical path reaching the light receiving portion, and the light transmitting portion contains heavy hydrogen. In the case where an imaging lens and a prism of a camera, and a microlens, a flattening film and a color filter of an imaging element are formed of an organic resin, the organic resin is deuterated. Moreover, the present invention suggests the light receiving device that can shift proper vibrations of respective bonds of C, O, Si and N with hydrogen, which may cause a decrease of a sensitivity, to a long wavelength side, by deuterating a silicon oxide film, a silicon nitride film and a silicon oxynitride film such as protective films and an interlayer insulating film in the imaging element, and has a high sensitivity in a visible light region and a near-infrared region, a method for manufacturing the same and a camera.

## Description

### Technical Field

The present invention relates to a light receiving device including an image sensor and the like, a method for manufacturing the same and a camera.

### Background Art

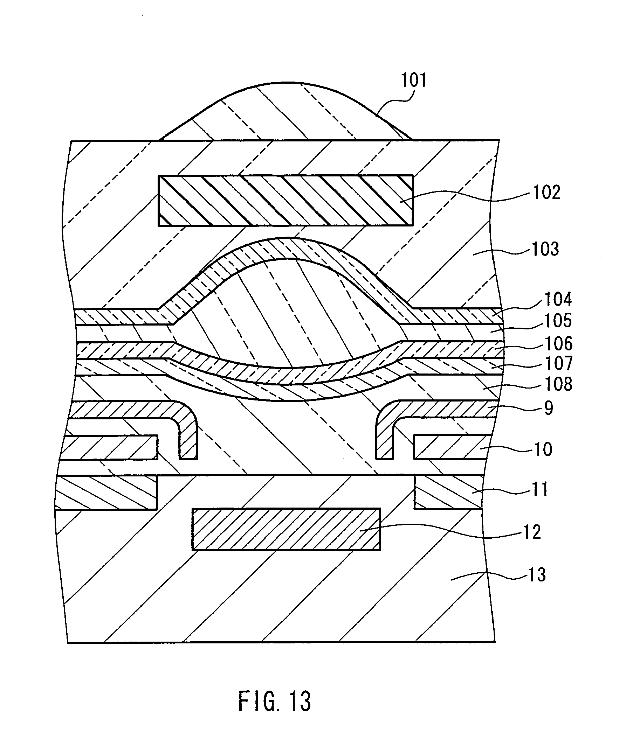

A conventional imaging device and a camera using the same will be described. FIG. 13 is a view showing a pixel cross-sectional structure of the conventional imaging device. In FIG. 13, reference numeral 101 denotes an organic microlens, 102 denotes an organic color filter, 103 denotes an organic flattening film, 104 denotes a first protective film, 105 denotes a second protective film, 106 denotes a third protective film, 107 denotes a fourth protective film, 108 denotes an interlayer insulating film, 9 denotes a light shielding film, 10 denotes a gate electrode, 11 denotes a vertical charge transfer portion, 12 denotes a photodiode, and 13 denotes a semiconductor substrate.

Using a charge transfer-type imaging element for an example, the pixel cross-sectional structure and functions of the respective members will be described with reference to FIG. 13. A pixel of the charge transfer-type imaging element is provided with: a photodiode 12 that is formed in a semiconductor substrate 13 and performs photoelectric conversion; and a gate electrode 10 for reading out a signal charge that is subjected to the photoelectric conversion to the vertical charge transfer portion 11, and outputting it to an outside, and an entire surface of an upper surface thereof is protected by the interlayer insulating film 108 and the protective films. In the example of FIG. 13, the protective films are composed of four layers: the first protective film 104; the second protective film 105; the third protective film 106; and the fourth protective film 107.

The first protective film 104 is provided as an antireflection film for reducing a loss caused by reflection of light at a boundary surface between: the organic flattening film 103 as an upper layer of the first protective film 104; and the second protective film 105 as a lower layer thereof, and has a refractive index that is about halfway between a refractive index of the organic flattening film 103 and a refractive index of the second protective film 105. For example, in the case where the organic flattening film 103 is an acrylic resin having the refractive index of about 1.6, and the second protective film 105 is a silicon nitride film having the refractive index of about 2.0, the first protective film 104 is formed of a silicon oxynitride film so as to achieve the refractive index of about 1.8.

The second protective film 105 has a lens shape on the photodiode 12 so as to contribute to improving the sensitivity as a so-called inlayer lens, and has an effect of trapping hydrogen that is supplied from the third protective film 106 and the fourth protective film 107 at the time of a heat treatment.

The third protective film 106 releases hydrogen at the time of the heat treatment in the manufacturing process so as to decrease an interface state density of a silicon substrate interface, and has an effect of enclosing the hydrogen in the cross-sectional structure. The fourth protective film 107 has a refractive index that is about halfway between a refractive index of the interlayer insulating film 108 and a refractive index of the third protective film 106 so as to reduce a loss of a sensitivity caused by reflection of light on a boundary between the interlayer insulating film 108 and the third protective film 106, and also has a function of supplying hydrogen at the time of the heat treatment similarly to the third protective film 106. In the case where the interlayer insulating film 108 is a silicon oxide film having the refractive index of about 1.5, and the third protective film 106 is a silicon oxide film having the refractive index of about 2.0, the fourth protective film 106 is formed of a silicon oxynitride film having the refractive index of about 1.7 so as to achieve the function described above.

On the protective film, the organic color filter 102 for obtaining a desired spectral characteristic is provided so as to correspond to the photodiode 12, and an entire surface of a surface thereof is flattened by the organic flattening film 103. Further, on the organic flattening film 103, the organic microlens 101 that corresponds to each photodiode 12 is provided.

Incident light into the imaging device passes through the organic microlens 101, is gathered toward the photodiode 12, passes through the organic flattening film 103, and reaches the organic color filter 102. Light having a desired wavelength passes through the organic color filter 102, passes through the first protective film 104 to the fourth protective film 107 and the interlayer insulating film 108, and reaches the photodiode 12 in the semiconductor substrate 13. The incident light generates a signal charge in the photodiode 12 by the photoelectric conversion, is carried to the vertical charge transfer portion 11 by the gate electrode 10 that is a read-out means, and is transferred.

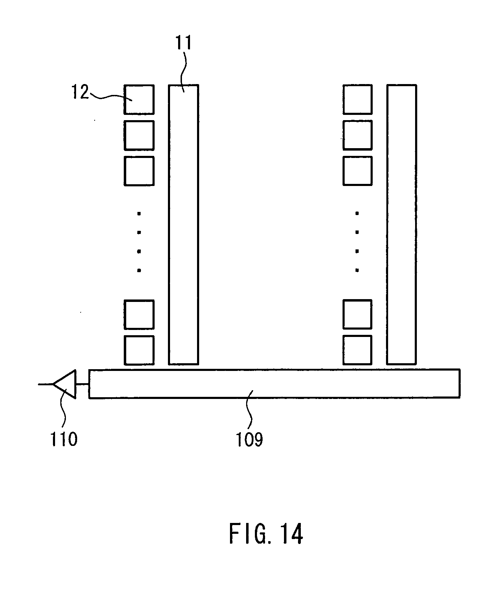

A charge transfer-type imaging element of an imaging element that is suggested in Non-patent document 1 will be described with reference to FIG. 14. In FIG. 14, reference numeral 11 denotes a vertical charge transfer portion, 12 is a photodiode, 109 denotes a horizontal charge transfer portion, and 110 denotes an output amplifier. In FIG. 14, the pixels shown in FIG. 13 are arranged in matrix, and have a function to output video information whose images are formed on a surface of the imaging element as a pattern of electric signals. In FIG. 14, only the photodiode 12 and the vertical charge transfer portion 11 of the pixels are shown. In the case of the charge transfer-type imaging element, the vertical charge transfer portion 11 is disposed between the photodiodes 12, and the signal charges accumulated in the photodiodes 12 sequentially are transferred to the horizontal charge transfer portion 109 by the vertical charge transfer portion 11. Further, the signal charges sequentially are transferred to the output amplifier 110 by the horizontal charge transfer portion 109, and voltage signals according to signal charge amounts are output to an outside of the imaging element in the order of the transferred signal charges. The vertical charge transfer portion 11 and the horizontal charge transfer portion 109 transfer the signal charges sequentially, whereby, from the video information whose images are formed on the surface of the imaging element, a pattern of the electric signals according to intensities of light near the respective pixels can be obtained.

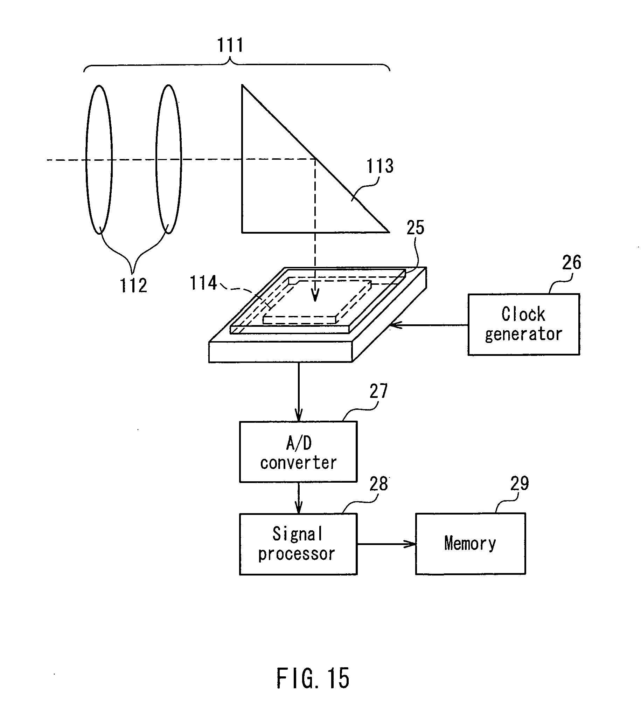

Next, functions of the camera suggested in Patent document 1 will be described with reference to FIG. 15. In FIG. 15, reference numeral 111 denotes an imaging optical system, 112 denotes an imaging lens, 113 denotes a prism, 114 denotes an imaging element, 26 denotes a clock generator, 27 denotes an A/D (analog/digital) converter, 28 denotes a signal processor, and 29 denotes a memory. The imaging lens 112 forms images of the external video information on the imaging element 114. In the imaging element 114, the vertical charge transfer portion 11, the horizontal charge transfer portion 109 and the output amplifier 110 shown in FIG. 13 are driven by the clock generator 26, and the video information is transferred to the A/D converter 27 as an electric signal. A brightness, a color, an aspect ratio of the image and the like of the video information that is digitalized by the A/D converter 27 are adjusted by the signal processor 28 as image information. Also, a data format as the image information is adjusted, and a data compression process may be performed as necessary. The image data whose data format is adjusted is stored into the memory 29 such as a magnetic tape.

Herein, the imaging lens 111 is illustrated as two convex lenses for simplicity, but actually is formed of two or more lenses in a combination of a convex lens, a concave lens, an aspheric lens and the like. Moreover, a camera that has the prism on an optical path of the imaging, and has an imaging optical system with a structure of bending of the optical path, inversion of the image, colorization by a plurality of the imaging elements and the like also exists.

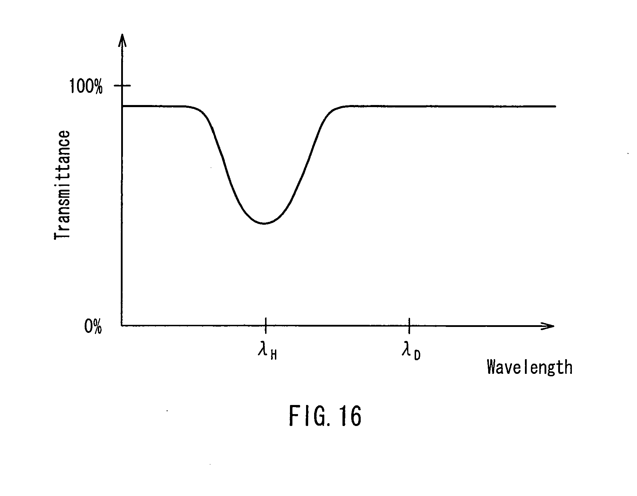

In such a conventional imaging element, a sensitivity is decreased due to transmission spectral characteristics of organic and inorganic materials containing much hydrogen. FIG. 16 schematically shows a spectral characteristic of a transmittance of a conventional material having a C-H bond. It has an absorption characteristic having a certain wavelength λ_{H} as a center. Since this results from vibrations of a bond between atoms, there also is absorption due to overtone vibrations such as ditone or tritone with respect to fundamental vibrations. When this absorption wavelength is present in sensitive wavelength bands of the camera and the imaging device, the sensitivity is decreased.

Each of the organic microlens 101, the organic flattening film 103 and the organic color filter 102 in the cross-sectional structure of the conventional solid-state imaging device shown in FIG. 13 has a C-H bond in a constituent molecule thereof. As shown in FIG. 16, a wavelength of a proper vibration of the C-H bond ranges from about 2.5 µm to 3 µm, and a transmittance in an infrared region of a wavelength ranging from about 2.5 µm to 3 µm is decreased significantly. Similarly, the absorption by the ditone vibrations is present at the wavelength of about 1.3 µm, the absorption by the tritone vibrations is present at the wavelength of about 900 nm, and the absorption by the tetratone vibrations is present at the wavelength of about 700 nm.

Similarly, in the case where the first protective film 104 to the fourth protective film 107 and the interlayer insulating film 108 of the imaging element are a silicon nitride film (SiNx), a silicon oxynitride film (SiOxNy) or a silicon oxide film (SiOx) formed by a CVD method, a gas such as a silane gas (SixH_{2X+2} such as SiH₄) and ammonia (NH₃) usually is used as a material when forming the film by the CVD method. Thus, in the silicon nitride film, the silicon oxynitride film or the silicon oxide film formed by the CVD method, a large amount of hydrogen exists in a state of bonding such as Si-H, N-H and O-H. Among them, the N-H bond and the O-H bond significantly decreases the transmittance in the infrared region of the wavelength ranging from about 2.5 µm to 3 µm, and its ditone vibrations decrease a transmittance of light in a visible light region, in particular, an infrared region and near-infrared region at a wavelength ranging from 700 nm to 1.5 µm.

Moreover, the Si-H bond decreases a transmittance of light at a short wavelength in the visible light region. In particular, in the case of providing a light condensing efficiency by processing the silicon nitride film or the silicon oxynitride film to have a lens-like cross-sectional shape like the second protective film 105 of FIG. 13 so as to form a so-called inlayer lens, there is a problem in that a film thickness of the silicon nitride film or the silicon oxynitride film is increased, and an influent by the decrease of the transmittance to the decrease of the sensitivity is increased.

Thus, the imaging element having the conventional organic microlens 101, the organic flattening film 103 or the organic color filter 102, and the silicon nitride film, the silicon oxynitride film or the silicon oxide film that is formed by the CVD method has a problem in that the sensitivity from the visible light region to the near-infrared region is decreased.

Moreover, the hydrogen supplied from the third protective film 106 and the fourth protective film 107 by the heat treatment in the manufacturing process has an effect of terminating a substrate interface state density of the imaging element and decreasing a dark current, but also has a problem in that, by continuing an imaging operation for a long period of time, the bond between silicon and hydrogen is released so as to cause deterioration of the dark current over time.

Similarly, also in a camera, an imaging lens or a prism made of an organic resin recently has been used often for the imaging optical system, for the processibility of an aspheric lens and the light-weight of the camera. Also, the imaging lens formed of an organic resin usually includes a C-H bond in its molecular structure and thus has a high absorptance in the visible light region, in particular, from the long wavelength end thereof to the near-infrared region, and has a problem in that the sensitivity of the camera using the imaging lens or the prism made of an organic resin is decreased in the visible light region, in particular, at the long wavelength end thereof and in the near-infrared region.
- Non-patent document 1:: Kazuya YONEMOTO, "Fundamental and application of CCD / CMOS image sensor", February 1, 2004, CQ Publishing Co.,Ltd., pp. 70-71
- Patent document 1:: JP 60(1985)-121374 U and the specification of its application

### Disclosure of Invention

In order to solve the conventional problems described above, the present invention is directed to a light receiving device with a high sensitivity in a visible light region and a near-infrared region, a method for manufacturing the same and a camera.

The light receiving device of the present invention includes: a light receiving portion formed on a semiconductor substrate; and a light transmitting portion containing an organic material on an optical path reaching the light receiving portion, wherein the light transmitting portion contains heavy hydrogen.

The camera of the present invention has the light receiving device described above.

The method for manufacturing a light receiving device of the present invention includes: a light receiving portion formed on a semiconductor substrate; and a light transmitting portion made of an organic material that has a photosensitivity on an optical path reaching the light receiving portion, the method including: a step of exposing the light transmitting portion; and a step of developing the light transmitting portion by an organic alkali developer that is obtained by substituting hydrogen with heavy hydrogen.

The method for manufacturing another light receiving device of the present invention includes: a light receiving portion formed on a semiconductor substrate; and a silicon nitride film or a silicon oxynitride film that is formed on the light receiving portion, wherein the silicon nitride film or the silicon oxynitride film is formed by a CVD method using a deuterated silane gas or deuterated ammonia.

### Brief Description of Drawings

[FIG. 1] FIG. 1 is a pixel cross-sectional view of a solid-state imaging device according to Embodiment 1 of the present invention.
[FIG. 2] FIG. 2 is a view schematically showing the spectral characteristic of a transmittance of an organic film according to Embodiment 1 of the present invention.
[FIG. 3] FIG. 3 is a view showing dependence of the transmittance of the organic film according to Embodiment 1 of the present invention on a deuteride rate at a carbon-hydrogen (C-H) absorption wavelength.
[FIG. 4] FIG. 4 is a view showing dependence of a refractive index of the organic film according to Embodiment 1 of the present invention on the deuteride rate.
[FIG. 5] FIG. 5 is a pixel cross-sectional view of a solid-state imaging device according to Embodiment 2 of the present invention.
[FIG. 6] FIG. 6 is a view schematically showing the spectral characteristic of a transmittance of a silicon nitride film according to Embodiment 2 of the present invention, regarding absorption of a Si-H bond and a Si-D bond.
[FIG. 7] FIG. 7 is a view showing dependence of the transmittance of the silicon nitride film according to Embodiment 2 of the present invention on a content of heavy hydrogen at a nitrogen-hydrogen (N-H) absorption wavelength.
[FIG. 8] FIG. 8 is a view showing dependence of a refractive index of the silicon nitride film according to Embodiment 2 of the present invention on a deuteride rate.
[FIG. 9] FIG. 9 is a view showing a structure of a camera according to one embodiment of the present invention.
[FIG. 10] FIG. 10 is a view schematically showing the spectral characteristic of a transmittance of an organic resin according to one embodiment of the present invention.
[FIG. 11] FIG. 11 is a view showing dependence of the transmittance of the organic resin according to one embodiment of the present invention on a deuteride rate at a carbon-hydrogen (C-H) absorption wavelength.
[FIG. 12] FIG. 12 is a view showing dependence of a refractive index of the organic resin according to one embodiment of the present invention on on a deuteride rate.
[FIG. 13] FIG. 13 is a view showing a pixel cross-sectional structure of a conventional imaging element.
[FIG. 14] FIG. 14 is a view showing a structure of a conventional imaging device.
[FIG. 15] FIG. 15 is a view showing a structure of a conventional camera.
[FIG. 16] FIG. 16 is a view schematically showing the spectral characteristic of a transmittance of a conventional material having a C-H bond.

### Description of the Invention

The present invention can realize a light receiving device, an imaging element and a camera that have high sensitivities in a visible light region and a near-infrared region, by substituting a carbon-hydrogen bond (a C-H bond) with a carbon-heavy hydrogen bond (a C-D bond), substituting a nitrogen-hydrogen bond (a N-H bond) with a nitrogen-heavy hydrogen bond (a N-D bond), substituting an oxygen-hydrogen bond (an O-H bond) with an oxygen-heavy hydrogen bond (an O-D bond), and substituting a silicon-hydrogen bond (a Si-H bond) with a silicon-heavy hydrogen bond (a Si-D bond), contained in an imaging lens and a prism of a camera formed of an organic resin, an organic microlens, an organic color filter, an organic flattening film, a protective film, an interlayer film and the like of an imaging element.

In the present invention, a light receiving portion formed on a semiconductor substrate and a light transmitting portion formed of an organic material on an optical path reaching the light receiving portion are provided, and the light transmitting portion contains heavy hydrogen. A content of the heavy hydrogen preferably ranges between 10 atomic % and 100 atomic % inclusive, where a total amount of the hydrogen and the heavy hydrogen is assumed to be 100 atomic %. In this range, the light receiving device can have an effectively high sensitivity in the visible light region and the near-infrared region.

The deuterated light transmitting portion may be a microlens or a color filter, and also may be a cover glass that is disposed on an upper side of the light receiving portion.

The light receiving device has a plurality of color filters that have different spectral characteristics, and at least one content of heavy hydrogen of: a color filter corresponding to a color filter that transmits a red wavelength of 650 nm or more or an infrared wavelength; and the light transmitting portion on the same optical path of the color filter preferably is higher than that of the light transmitting portion on the same optical path of another color filter or the above-described color filter.

Moreover, the light transmitting portion is a silicon nitride film, a silicon oxynitride film or a silicon oxide film that is formed on the light receiving portion, and the silicon nitride film, the silicon oxynitride film or the silicon oxide film preferably contains heavy hydrogen.

Moreover, the light transmitting portion preferably is an imaging lens or a prism that is provided separately from the semiconductor substrate.

By allowing the interlayer film and the protective films of the imaging element to contain the heavy hydrogen as described above, an effect that the heavy hydrogen contributes to an end of a substrate interface state density by a heat treatment and improves a dark current of the imaging element and its characteristic of degradation over time also can be obtained.

Also in an imaging lens and a prism of a camera formed of an organic resin, by substituting a carbon-hydrogen bond (a C-H bond) in the organic resin with a carbon-heavy hydrogen bond (a C-D bond), absorption at a long wavelength end and in a near-infrared region in a visible light region is less than that of the conventional one, and an amount of light incident into the imaging element is increased, thereby being able to improve the sensitivity at the long wavelength end and in the near-infrared region in a visible light region.

Herein, the carbon-hydrogen bond (the C-H bond) in molecules of the organic microlens, the organic color filter and the organic flattening film is substituted with the carbon-heavy hydrogen bond (the C-D bond). Assuming that an atomic weight of the carbon is 12, an atomic weight of the hydrogen is 1, and an atomic weight of the heavy hydrogen is 2, an obtained effective mass of the hydrogen in the C-H bond is about 0.92, whereas an effective mass of the heavy hydrogen in the C-D bond is 1.71.

Accordingly, the wavelength of fundamental vibrations of the C-D bond is about 1.85 times the wavelength of fundamental vibrations of the C-H bond. That is, by substituting the hydrogen with the heavy hydrogen, an absorption wavelength ranging from 2.5 µm to 3 µm that is resulted from the C-H bond is changed into a range from about 5 µm to 6 µm, absorption of 1.3 µm is changed into about 2.4 µm, absorption of 900 nm is changed into about 1.7 µm, and absorption of 700 nm is changed into about 1.3 µm. Thereby, absorption of a deuterated organic microlens and a deuterated organic color filter in a visible light region, in particular, at a long wavelength end thereof and in a near-infrared region, is smaller than that of conventional one, and the amount of light that is incident into a photodiode is increased, thereby being able to improve the sensitivity in the visible light region, in particular, at the long wavelength end thereof and in the near-infrared region.

Similarly, also in the case where the first protective film 104 to the fourth protective film 107 and the interlayer insulating film 108 shown in FIG. 13 are the silicon nitride film, the silicon oxynitride film and the silicon oxide film formed by the CVD method, an effect similar to the case of the C-H bond can be obtained by deuterating the N-H bond into the N-D bond and deuterating the O-H bond into the O-D bond.

In particular, in the CVD method for the silicon nitride film and the silicon oxynitride film, a silane gas and ammonia respectively are used as sources of silicon and nitrogen in most cases, but, since most of the hydrogen contributing to the N-H bond in the formed film results from the silane gas, it is effective to deuterate the silane gas. Also, by deuterating other gas such as ammonia, many of the Si-H bonds in the silicon nitride film and the silicon oxynitride film are changed into a Si-D bond, and the sensitivity in the visible light region at a relatively short wavelength also can be improved.

In the silicon oxide film, by forming the film using a deuterated silane gas, the Si-H bond is changed into the Si-D bond, and the sensitivity in the visible light region at the relatively short wavelength similarly can be improved. For example, in the case of a monosilane gas (SiH₄), SiD₄ that is fully deuterated is most preferable, but even monosilane gases (SiHD₃, SiH₂D₂ and the like) that are partly deuterated also can provide a part of the effect. Other materials also are applied similarly.

### (Embodiment 1)

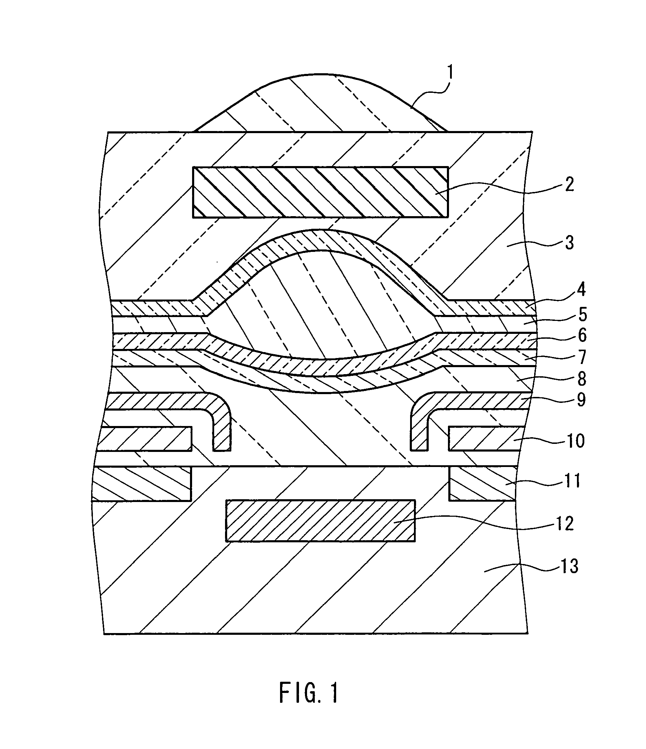

Embodiment 1 of the present invention will be described with reference to the figures. FIG. 1 is a view showing a pixel cross-sectional structure of an imaging element according to Embodiment 1 of the present invention. In FIG. 1, reference numeral 1 denotes an organic microlens, 2 denotes an organic color filter, 3 denotes an organic flattening film, 4 denotes a first protective film, 5 denotes a second protective film, 6 denotes a third protective film, 7 denotes a fourth protective film, 8 denotes an interlayer insulating film, 9 denotes a light shielding film, 10 denotes a gate electrode, 11 denotes a vertical charge transfer portion, 12 denotes a photodiode, and 13 denotes a semiconductor substrate.

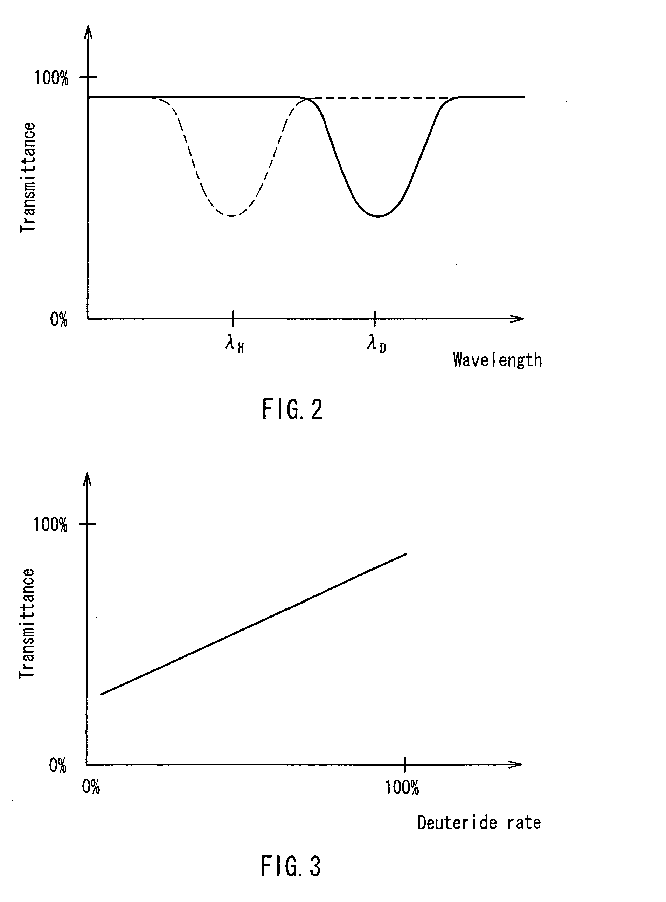

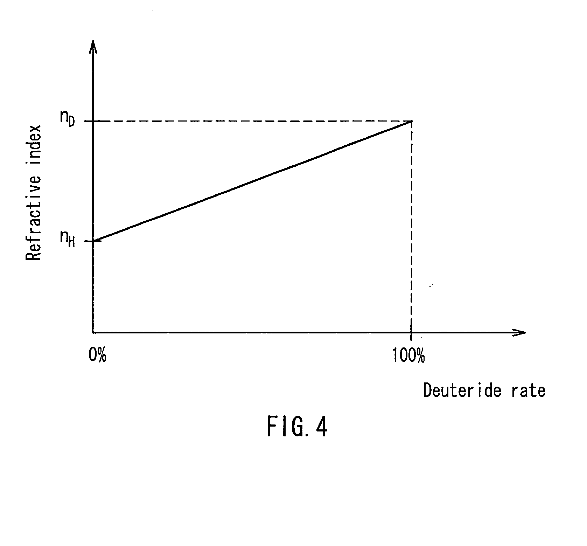

FIG. 2 is a view schematically showing the spectral characteristic of a transmittance of an organic film, a dotted line in the figure shows a spectral characteristic of a film containing normal hydrogen (H₂), and a solid line shows a spectral characteristic of a film in which all of hydrogen in the film is heavy hydrogen. FIG. 3 is a view showing dependence of the transmittance of the organic film on a deuteride rate at a carbon-hydrogen (C-H) absorption wavelength. FIG. 4 is a view showing dependence of a refractive index of the organic film on the deuteride rate.

In the imaging element according to Embodiment 1 of the present invention, a carbon-hydrogen bond (a C-H bond) in molecules of the organic microlens 1, the organic color filter 2 and the organic flattening film 3 is substituted with a carbon-heavy hydrogen bond (a C-D bond), and a concentration ratio of the heavy hydrogen with respect to the hydrogen is sufficiently higher than 0.1% that is a concentration ratio in the realm of nature.

Incident light into the imaging device is transmitted through the organic microlens 1, is condensed toward the photodiode 12, is transmitted through the organic flattening film 3, and reaches the organic color filter 2. Light at a desired wavelength is transmitted through the organic color filter 2, is transmitted through the first protective film 4 to the fourth protective film 7 and the interlayer insulating film 8, and reaches the photodiode 12 that is formed in the semiconductor substrate 13. The incident light generates a signal charge by photoelectric conversion in the photodiode 12, and is carried to the vertical charge transfer portion 11 by the gate electrode 10 that is a read-out means, and is transferred to the output portion.

An effect of improving the sensitivity in the present embodiment will be described below. Transmission spectral characteristics of an organic material and an inorganic material containing much hydrogen have absorption characteristics that respectively have, as centers, certain wavelengths corresponding to proper vibrations of the C-H bond and the O-H bond, and the proper vibrations depend on weights of atoms that are contribute to the bonds.

An effective mass of hydrogen in the C-H bond is about 0.92, which is obtained by assuming that an atomic weight of carbon is 12, an atomic weight of hydrogen is 1, and an atomic weight of heavy hydrogen is 2, whereas, an effective mass of the heavy hydrogen in the C-D bond is 1.71. Accordingly, a wavelength of fundamental vibrations of the C-D bond is about 1.85 times a wavelength of fundamental vibrations of the C-H bond. That is, by substituting the hydrogen with the heavy hydrogen, an absorption wavelength ranging from 2.5 µm to 3 µm that is contributed by the C-H bond is changed into a range from about 5 µm to 6 µm, absorption of 1.3 µm is changed into about 2.4 µm, absorption of 900 nm is changed into about 1.7 µm, and absorption of 700 nm is changed into about 1.3 µm.

This phenomenon will be shown schematically in FIG. 2. In the present embodiment, a dotted line corresponds to an absorption characteristic having a center at λ_{H} by the C-H bond, and a solid line corresponds to an absorption characteristic having a center at λ_{D} by the C-D bond that is longer than λ_{H}. By substituting the C-H bond with the C-D bond, the central wavelength of the absorption becomes longer, and a transmittance at the original absorption wavelength λ_{H} is improved.

Thereby, in a visible light region of the organic microlens 1, the organic color filter 2 and the organic flattening filter 3 that are deuterated, in particular, at a long wavelength end thereof and in a near-infrared region, the central wavelength of the absorption becomes longer, so that the absorption of light is less than that of the conventional one, an amount of light incident into the photodiode 12 is increased, and the sensitivity in the visible light region, in particular, at the long wavelength end thereof and in the near-infrared region can be improved.

In order to realize such a structure, the organic microlens 1, the organic color filter 2 and the organic flattening film 3 of the imaging element of the present embodiment are formed of a resin that is synthesized by using a deuterated raw material. Further, in the case where the organic microlens 1, the organic color filter 2 and the organic flattening film 3 are positive-type photoresists, by also deuterating an organic alkali developer, it becomes possible to achieve perfect deuteration including that of a hardly-soluble layer that is formed by reacting the organic alkali developer with the photoresist.
A content of the heavy hydrogen is preferably 100% in atomic ratio, but even the deuteration in part also can provide the effect. The content of the heavy hydrogen preferably ranges between 10 atomic % and 100 atomic % inclusive.

The heavy hydrogen and the normal hydrogen can be analyzed by analyzing means including: mass spectroscopy such as secondary ion spectroscopy and inductively coupled plasma mass spectroscopy; and chemical bond analyses such as a Fourier infrared spectroscopic analysis and Raman spectroscopy.

Due to the dependence of a transmittance of a transparent film of FIG. 3 on the content of the heavy hydrogen, the transmittance of the light at the carbon-hydrogen (C-H) absorption wavelength is improved more in proportional to the content of the heavy hydrogen in the present embodiment. The content of the heavy hydrogen with respect to a total amount of the hydrogen and the heavy hydrogen in the organic microlens 1, the organic color filter 2 and the organic flattening film 3 is preferably 10% or more in atomic ratio. More preferably, the ratio of the heavy hydrogen is 20% or more. The reason for this is because, when the ratio is 20% or more, an absorptance is improved by about 5%, and a sensitivity improving effect for the imaging element can be recognized clearly. Herein, when the atomic ratio of the heavy hydrogen is 10% or more, the sensitivity improving effect can be detected.

As shown in FIG. 4, since a refractive index is increased by deuterating the hydrogen contained in the transparent film, it is possible to improve a light condensing efficiency by optimizing a curvature of the organic microlens 1 or the like, and also obtain a still higher sensitivity.

In the embodiment of the present invention, the case where all of the films including the organic microlens 1, the organic color filter 2 and the organic flattening film 33 are deuterated was described, but the effect can be obtained also by deuterating a part of the films. Also, by deuterating only the organic color filter 2 of a certain spectrum, only the spectrum can be improved.

It should be noted that the embodiment of the present invention is described by using the charge transfer-type imaging element as an example, but an imaging element of other system such as a MOS-type imaging device, and a light receiving device used for a photo-coupler or the like also can provide the similar effect.

### (Embodiment 2)

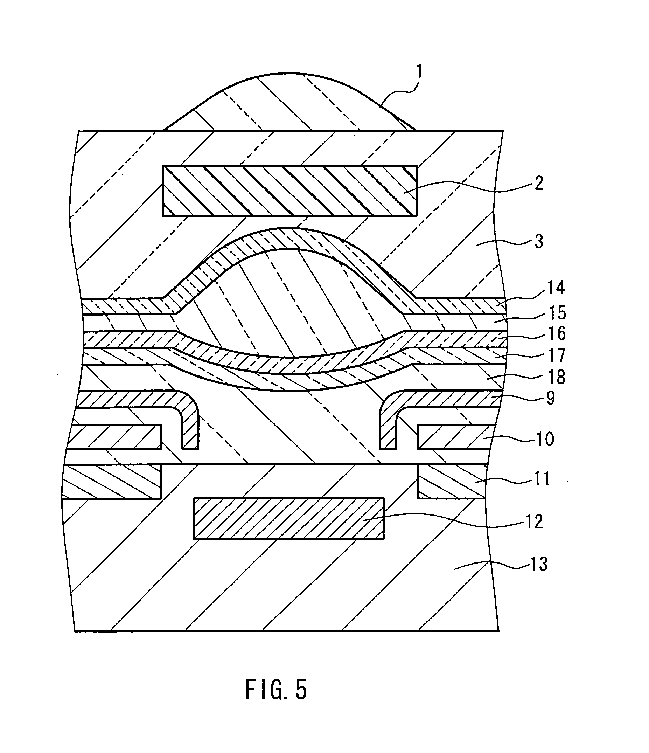

FIG. 5 is a view showing a pixel cross-sectional structure of an imaging device according to Embodiment 2 of the present invention. In FIG. 5, reference numeral 1 denotes an organic microlens, 2 denotes an organic color filter, 3 denotes an organic flattening film, 14 denotes a first protective film, 15 denotes a second protective film, 16 denotes a third protective film, 17 denotes a fourth protective film, 18 denotes an interlayer insulating film, 9 denotes a light shielding film, 10 denotes a gate electrode, 11 denotes a vertical charge transfer portion, 12 denotes a photodiode, and 13 denotes a semiconductor substrate.

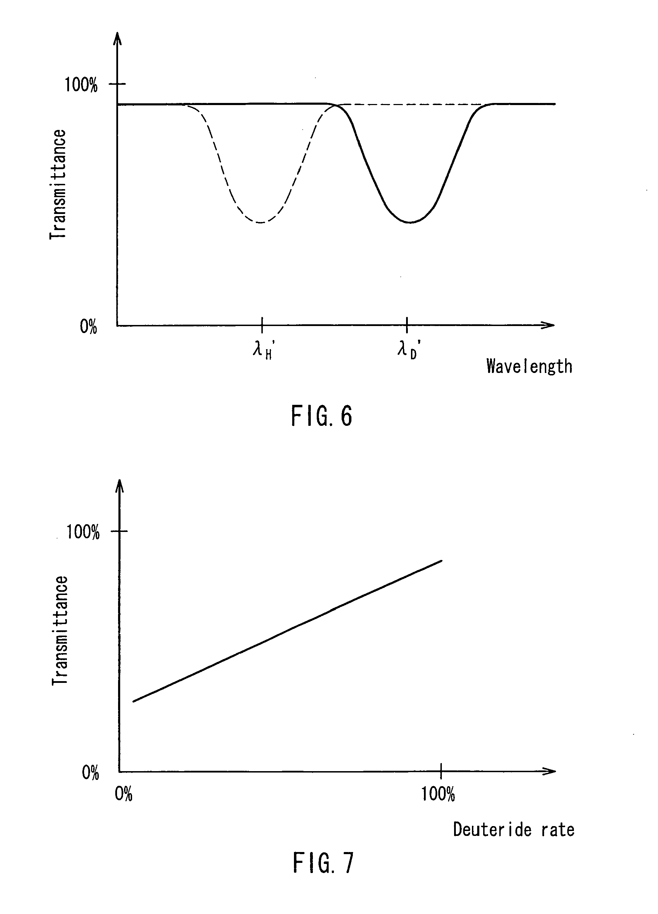

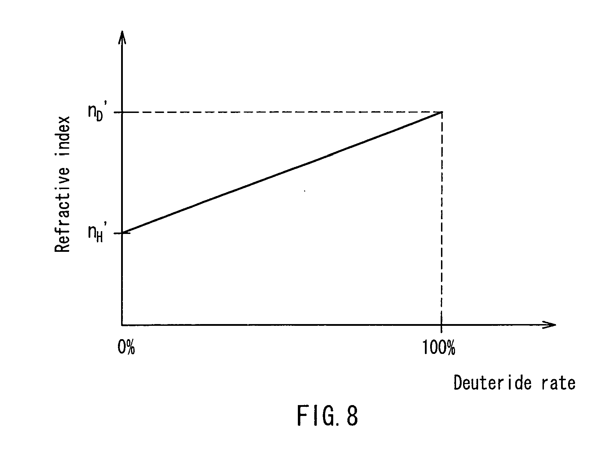

FIG. 6 is a view schematically showing the spectral characteristic of a transmittance of a silicon nitride film regarding absorption of a Si-H bond and a Si-D bond, and a dotted line in the figure shows the spectral characteristic of a silicon nitride film containing normal light hydrogen, and a solid line shows the spectral characteristic of a silicon nitride film in which all of hydrogen in the film is heavy hydrogen. FIG. 7 is a view showing dependence of a transmittance of the silicon nitride film on a content of the heavy hydrogen at a nitrogen-hydrogen (N-H) absorption wavelength. FIG. 8 is a view showing dependence of a refractive index of the silicon nitride film on a deuteride rate.

An imaging element according to the embodiment of the present invention includes: the first protective film 14 to the fourth protective film 17, each of which is made of a laminate film of a silicon nitride film and a silicon oxynitride film; and the interlayer insulating film 18 made of a silicon oxide film, and in these protective films and the interlayer insulating film 18, a nitrogen-hydrogen bond (a N-H bond) is substituted with a nitrogen-heavy hydrogen bond (a N-D bond), a silicon-hydrogen bond (a Si-H bond) is substituted with a silicon-heavy hydrogen bond (a Si-D bond), and an oxygen-hydrogen bond (an O-H bond) is substituted with an oxygen-heavy hydrogen bond (an O-D bond), so that a concentration ratio of the heavy hydrogen with respect to the hydrogen is sufficiently higher than 0.1% that is a concentration ratio in the realm of nature.

Incident light into the imaging device is transmitted through the organic microlens 1, is condensed toward the photodiode 12, is transmitted through the organic flattening film 3, and reaches the organic color filter 2. Light at a desired wavelength is transmitted through the organic color filter 2, is transmitted through the first protective film 14 to the fourth protective film 17 and the interlayer insulating film 18, and reaches the photodiode 12 that is formed in the semiconductor substrate 13. The incident light generates a signal charge by photoelectric conversion in the photodiode 12, and is carried to the vertical charge transfer portion 11 by the gate electrode 10 that is a read-out means, and is transferred to an output portion.

An effect to improve a sensitivity in the present embodiment will be described below. Transmission spectral characteristics of the silicon oxide film and the silicon nitride film containing much hydrogen have absorption characteristics that respectively have, as centers, certain wavelengths corresponding to proper vibrations of the N-H bond, the Si-H bond and the O-H bond, and the proper vibrations depend on weights of atoms that contribute to the bonds.

Similarly to the case of Embodiment 1, by substituting the conventional light hydrogen contained in the silicon oxide film, the silicon nitride film and the silicon oxynitride film with heavy hydrogen, the wavelengths of the proper vibrations of the conventional N-H bond, the Si-H bond and the O-H bond are increased. This phenomenon will be shown schematically in FIG. 6. In the case of the silicon nitride film of the present embodiment, a dotted line corresponds to an absorption characteristic having a center at λ'_{H} by the Si-H bond, and a solid line corresponds to an absorption characteristic having a center at λ'_{D} by the Si-D bond. λ'_{D} is a wavelength longer than λ'_{H}. By substituting the Si-H bond with the Si-D bond, the central wavelength of the absorption becomes longer, and a transmittance at the original absorption wavelength λ'_{H} is improved. This also is applied to the N-H bond and the O-H bond.

As described above, in a visible light region, at a long wavelength end thereof and in a near-infrared region of the first protective film 14 to the fourth protective film 17 and the interlayer insulating film 18 that are deuterated, by increasing the central wavelength of the absorption, the absorption of the light becomes smaller than that of the conventional one, an amount of the light incident into the photodiode 12 is increased, and the sensitivity in the visible light region, at the long wavelength end thereof and in the near-infrared region can be improved.

In order to realize the imaging element with such a structure, the imaging element of the present example is formed by a CVD method using materials that are obtained by deuterating the protective films and the interlayer insulating film.

In particular, in the CVD method for the silicon nitride film and the silicon oxynitride film, a silane gas and ammonia respectively are used as sources of silicon and nitrogen in most cases, but, since most of the hydrogen contributing to the N-H bond in the formed film comes from the silane gas, it is effective to deuterate the silane gas. Also, by deuterating other gas such as ammonia, many of the Si-H bond in the silicon nitride film and the silicon oxynitride film is changed into a Si-D bond, and the sensitivity in the visible light region at a relatively short wavelength also can be improved.

Also in the silicon oxide film, by forming the film using a deuterated silane gas, the Si-H bond is changed into the Si-D bond, and the sensitivity in the visible light region at the relatively short wavelength similarly can be improved.

For example, in the case of a monosilane gas (SiH₄), SiD₄ that is fully deuterated is most preferable, but even monosilane gases (SiHD₃, SiH₂D₂ and the like) that are partly deuterated also can provide a part of the effect.

### Other materials are applied similarly.

Moreover, by allowing the interlayer film and the protective films of the imaging element to contain the heavy hydrogen, an effect that the heavy hydrogen contributes to an end of a substrate interface state density by a heat treatment and improves a dark current of the imaging element and its characteristic of degradation over time also can be obtained. The content of the heavy hydrogen is preferably 100% in atomic ratio, but the deuteration in part also provides the effect.

Due to the dependence of the transmittance of the silicon nitride film of FIG. 7 on the content of the heavy hydrogen, the transmittance of the light at the silicon-hydrogen (Si-H) absorption wavelength and the nitrogen-hydrogen (N-H) absorption wavelength is improved more in proportion to the content of the heavy hydrogen in the present embodiment. The content of the heavy hydrogen with respect to a total amount of the hydrogen and the heavy hydrogen in the first protective film 14 to the fourth protective film 17 and the interlayer insulating film 18 is preferably 10% or more in atomic ratio, and further, 20% or more is preferable because an absorptance is improved by about 5%, and a sensitivity improving effect as the imaging element can be recognized clearly. Herein, when the atomic ratio of the heavy hydrogen is 10% or more, the sensitivity improving effect can be detected.

As shown in FIG. 8, since a refractive index of the silicon oxynitride film or the silicon nitride film is increased by about 10% at maximum by the deuteration, it is possible to improve a light condensing efficiency by optimizing a curvature of the second protective film 15 in FIG. 5, and also obtain a still higher sensitivity.

In the embodiment of the present invention, all of the first protective film 14 to the fourth protective film 17 and the interlayer insulating film 18 are deuterated, but the similar effect can be obtained also in the case where a part of the films constituting them is deuterated.

The embodiment of the present invention can provide a higher effect by being combined with Embodiment 1.

It should be noted that the embodiment of the present invention is described by using the charge transfer-type imaging element as an example, but an imaging element of other system such as a MOS-type imaging device, and a light receiving device used for a photo-coupler or the like also can provide the similar effect.

### (Embodiment 3)

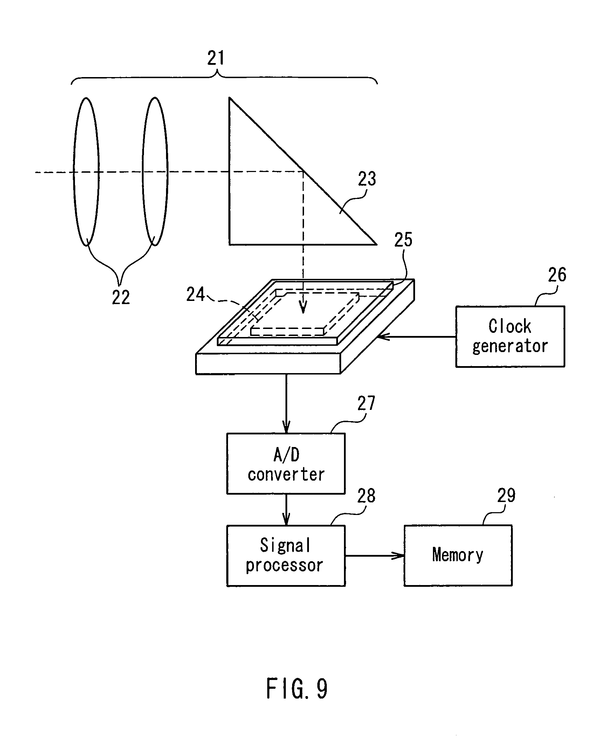

Embodiment 3 of the present invention will be described with reference to the figures. FIG. 9 is a view showing a structure of a camera according to the embodiment of the present invention, and in FIG. 9, reference numeral 21 denotes an imaging optical system, 22 denotes an imaging lens, 23 denotes a prism, 24 denotes an imaging element, 26 denotes a clock generator, 27 denotes an A/D converter, 28 denotes a signal processor, and 29 denotes a memory.

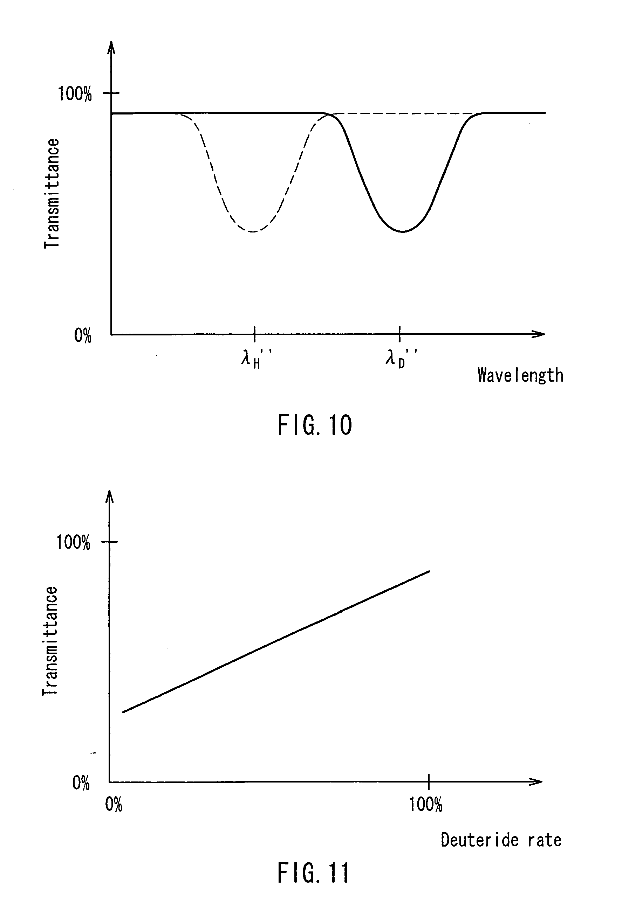

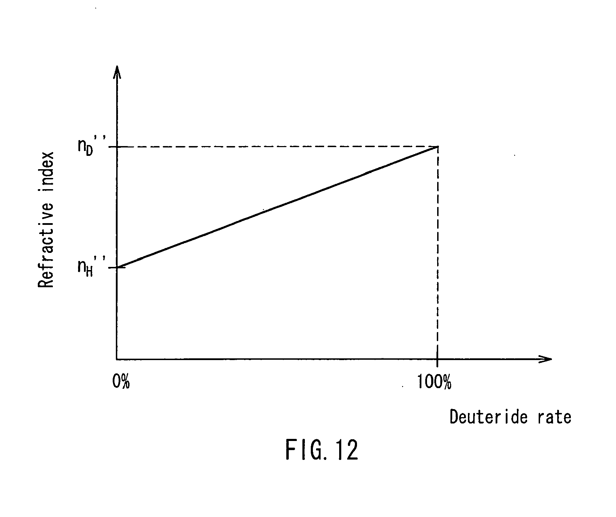

FIG. 10 is a view schematically showing the spectral characteristic of a transmittance of an organic film, a dotted line in the figure shows a spectral characteristic of a resin containing conventional light hydrogen, and a solid line shows a spectral characteristic of a resin in which all of hydrogen in the film is heavy hydrogen. FIG. 11 is a view showing dependence of the transmittance of the organic resin on a deuteride rate at a carbon-hydrogen (C-H) absorption wavelength. FIG. 12 is a view showing dependence of a refractive index of the organic resin on a deuteride rate.

The camera according to the embodiment of the present invention is provided with an imaging lens 22 and a prism 23 formed of organic resins, and the organic resins contain heavy hydrogen instead of light hydrogen. A ratio of the heavy hydrogen with respect to the all hydrogen in the organic resins of the present embodiment is sufficiently higher than 0.1% that is a ratio in the realm of nature.

The imaging lens 22 and the prism 23 constituting the imaging optical system 21 form images of external video on the imaging element.
The imaging element 24 converts the video and an intensity of light into an electric signal, and transfers it to the A/D converter 27. A brightness, a color, an aspect ratio of the image and the like, as image information, of the video information that is digitalized by the A/D converter 27 are adjusted by the signal processor 28. Also, a data format as the image information is adjusted, and the image data is stored in the memory 29 such as a magnetic tape. Herein, the imaging lens 21 is illustrated as two convex lenses for simplicity, but actually is formed of two or more lenses of a combination of a convex lens, a concave lens, an aspheric lens and the like.

An effect to improve a sensitivity in the present embodiment will be described below. Transmission spectral characteristics of the organic resin containing much hydrogen have absorption characteristics that respectively have, as centers, certain wavelengths corresponding to proper vibrations of the C-H bond and the O-H bond, and the proper vibrations depend on weights of atoms that contribute to the bonds.

An effective mass of hydrogen in the C-H bond is about 0.92, which is obtained by assuming that an atomic weight of carbon is 12, an atomic weight of hydrogen is 1, and an atomic weight of heavy hydrogen is 2, whereas, an effective mass of heavy hydrogen in the C-D bond is 1.71. Accordingly, a wavelength of fundamental vibrations of the C-D bond is about 1.85 times a wavelength of fundamental vibrations of the C-H bond. That is, by substituting the hydrogen with the heavy hydrogen, an absorption wavelength ranging from 2.5 µm to 3 µm that is contributed by the C-H bond is changed into a range from about 5 µm to 6 µm, absorption of 1.3 µm is changed into about 2.4 µm, absorption of 900 nm is changed into about 1.7 µm, and absorption of 700 nm is changed into about 1.3 µm.

This phenomenon will be schematically shown in FIG. 10. In the present embodiment, a dotted line corresponds to an absorption characteristic having a center at λ_{H} by the C-H bond, and a solid line corresponds to an absorption characteristic having a center at λ_{D} by the C-D bond. λ"_{D} is a wavelength longer than λ"_{H}. By substituting the C-H bond with the C-D bond, the central wavelength of the absorption becomes longer, and a transmittance at the original absorption wavelength λ"_{H} is improved.

Thereby, in a visible light region in the imaging optical system 21 including the imaging lens 22 and the prism 23 that are deuterated, at a long wavelength end thereof and in a near-infrared region, the central wavelength of the absorption becomes longer, so that the absorption of light is less than that of a conventional one, an amount of light incident into the imaging element 24 is increased, and the sensitivity in the visible light region, at the long wavelength end thereof and in the near-infrared region can be improved.

In order to realize such a structure, the imaging lens 22 and the prism 23 of the camera of the present embodiment are formed of a resin that is synthesized by using a deuterated raw material. A content of the heavy hydrogen is preferably 100% in atomic ratio, but even the deuteration in part also can provide the effect.

Due to the dependence of the transmittance of the transparent film of FIG. 11 on the content of the heavy hydrogen, the transmittance of the light at the carbon-hydrogen (C-H) absorption wavelength is improved more in proportion to the content of the heavy hydrogen in the present embodiment. The content of the heavy hydrogen with respect to a total amount of the hydrogen and the heavy hydrogen in each of the imaging lens 22 and the prism 23 is preferably 10% or more in atomic ratio, and further, 20% or more is preferable because an absorptance is improved by about 5%, and a sensitivity improving effect as the imaging element can be recognized clearly. Herein, when the atomic ratio of the heavy hydrogen is 10% or more, the sensitivity improving effect can be detected.

As shown in FIG. 12, since the refractive index is increased by deuterating the hydrogen contained in the transparent film, it is possible to improve an optical characteristic by optimizing a curvature of the imaging lens 22. Moreover, the imaging lens 22 having less astigmatism that corresponds to an aspheric lens can be formed by changing the deuteride rate on a concentric circle from an optical center toward a periphery thereof.

In the embodiment of the present invention, the case where all of the imaging lens and the prism are deuterated was described, but the effect can be obtained if a part of them or other optical member is deuterated.

As the cover glass that is disposed as a front surface of the imaging element, a quartz glass or the like that has a high permeability usually is used, but it also is possible to replace the cover glass with a transparent resin plate, and mold the imaging device with a transparent resin so as to replace the cover glass. In this case, the similar effect can be obtained by deuterating these transparent resins.

Further, the similar effect can be obtained also by deuterating an optical adhesive agent that is used when adhering the optical members in the imaging optical path such as the cover glass and the prism.

If the imaging element in the camera of the present embodiment realizes Embodiment 1 or Embodiment 2 of the present invention, the sensitivity can be increased more.

## Claims

1. A light receiving device comprising: a light receiving portion formed on a semiconductor substrate; and a light transmitting portion containing an organic material on an optical path reaching the light receiving portion,
wherein the light transmitting portion contains heavy hydrogen.

2. The light receiving device according to claim 1, wherein the light transmitting portion is a microlens that is formed on the light receiving portion.

3. The light receiving device according to claim 1, wherein the light transmitting portion is a cover glass to be provided on an upper side of the light receiving portion.

4. The light receiving device according to claim 1, wherein the light transmitting portion is a color filter.

5. The light receiving device according to claim 1, wherein the light transmitting portion is a silicon nitride film, a silicon oxynitride film or a silicon oxide film that is formed on the light receiving portion, and the silicon nitride film, the silicon oxynitride film or the silicon oxide film contains heavy hydrogen.

6. The light receiving device according to claim 1, wherein the light transmitting portion is an imaging lens or a prism that is provided separately from the semiconductor substrate.

7. The light receiving device according to claim 1, comprising a plurality of color filters having different spectral characteristics,
wherein a content of heavy hydrogen in at least one of: a color filter corresponding to a color filter that transmits a red or infrared wavelength of 650 nm or more; and a light transmitting portion on an optical path that is the same as an optical path of the color filter is higher than a light transmitting portion on an optical path that is the same as an optical path of another color filter or the color filter.

8. The light receiving device according to any one of claims 1 to 7,
wherein the content of the heavy hydrogen ranges between 10 atomic % and 100 atomic % inclusive, where a total amount of hydrogen and the heavy hydrogen is assumed to be 100 atomic %.

9. The light receiving device according to claim 1, wherein the light receiving portion is a hardly-soluble layer that is obtained by allowing a deuterated organic alkali developer to react with a photoresist.

10. A camera comprising the light receiving device according to any one of claims 1 to 7.

11. A method for manufacturing a light receiving device comprising: a light receiving portion formed on a semiconductor substrate; and a light transmitting portion made of an organic material that has a photosensitivity on an optical path reaching the light receiving portion,
the method comprising:
a step of exposing the light transmitting portion; and
a step of developing the light transmitting portion by an organic alkali developer that is obtained by substituting hydrogen with heavy hydrogen.

12. A method for manufacturing a light receiving device comprising: a light receiving portion formed on a semiconductor substrate; and a silicon nitride film or a silicon oxynitride film that is formed on the light receiving portion,
wherein the silicon nitride film or the silicon oxynitride film is formed by a CVD method using a deuterated silane gas or deuterated ammonia.
